# EUROPEAN PATENT APPLICATION

(11) **EP 3 141 629 A1**
(43) Date of publication of application: **15.03.2017**
(21) Application number: 16186508.4
(22) Date of filing: 31.08.2016
(51) Int. Cl.: C23C 4/129, C23C 4/01, C23C 4/18, C23C 24/04, F01D 5/00

(54) **ARTICLE TREATMENT METHODS**

(30) Priority: 10.09.2015 US 201514850322
(71) Applicant: General Electric Company, Schenectady, NY 12345 (US)
(72) Inventor: SCHAEFFER, Jon Conrad, Greenville, SC 29615 (US); DETOR, Andrew Joseph, Niskayuna, NY 12309 (US)
(74) Representative: Pöpper, Evamaria

(57) **Abstract**

An article (100) treatment method includes providing the article (100) including a substrate (102) composed of a substrate material (104) having an undesirable substrate feature (106). The undesirable substrate feature (106) may include a recess (112), and a portion of the substrate (102) containing the undesirable substrate feature (106) may be removed to form a recess (112) in a surface (108) of the substrate (102). A feedstock mixture (304) including a filler material (302) and a liquid carrier (306) is introduced into an HVAF apparatus (300) having a combustion gas stream (308) with a temperature greater than the melting point of the filler material (302). The filler material (302) is applied to the recess (112) by expelling the filler material (302) while maintained at a temperature less than the melting point of the filler material (302) by the liquid carrier (306). The filler material (302) and an area of the substrate (102) bordering the recess (112) are heat treated, forming a treated portion (400).

## Description

### FIELD OF THE INVENTION

The present invention is directed to methods for treating articles. More particularly, the present invention is directed to methods for treating articles such as turbine components including application of filler material to replace an undesirable substrate feature using a high-velocity-air-fuel apparatus.

### BACKGROUND OF THE INVENTION

Hard-to-weld (HTW) alloys, such as nickel-based superalloys and certain aluminum-titanium alloys, due to their gamma prime and various geometric constraints, are susceptible to gamma prime strain aging, liquation and hot cracking. These materials are also difficult to join when the gamma prime phase is present in volume fractions greater than about 30%, which may occur when aluminum or titanium content exceeds about 3%.

These HTW materials may be incorporated into gas turbine engines, forming components of the gas turbine engines such as blades (buckets), nozzles (vanes), shrouds, combustors, rotating turbine components, wheels, seals, 3d-manufactured components with HTW alloys and other hot gas path components. Cracks, divots, abrasions, pores, deviant grains and other physical or chemical undesirable features may form in the HTW material during casting, formation, machining, servicing or operation of the component including the HTW material. Repairs of such undesirable substrate features are impaired by the difficulty in joining HTW materials, making standard repair techniques such as patching or filling a crack with an HTW material difficult. Filling in such undesirable substrate features using hot processes such as conventional thermal spray yields deposited material which is weakened or cracked by the elevated temperatures. Brazing techniques are unsuitable because braze materials or elements are incorporated into the component which may not meet operational requirements.

Cosmetic repair of undesirable substrate features may currently be performed, but such cosmetic repairs lack the original mechanical properties of the HTW material, and result in components which have inferior durability and performance characteristics.

### BRIEF DESCRIPTION OF THE INVENTION

In an exemplary embodiment, an article treatment method includes introducing a feedstock mixture including a filler material and a liquid carrier into a combustion gas stream of a high-velocity-air-fuel (HVAF) apparatus. The combustion gas stream has a temperature greater than a melting point of the filler material. An entrained feedstock stream is formed from the feedstock mixture within the HVAF apparatus. The filler material is applied to an article including a substrate composed of a substrate material, the substrate including an undesirable substrate feature including a recess in a surface of the substrate. Applying the filler material to the article includes applying the filler material to the recess by expelling the filler material from the HVAF apparatus, the filler material being maintained at a temperature less than the melting point of the filler material by the liquid carrier while being expelled. The filler material and an area of the substrate bordering the recess are heat treated, forming a treated portion.

In another exemplary embodiment, an article treatment method includes removing a portion of a substrate of an article, the substrate being composed of a substrate material, and the portion of the substrate containing an undesirable substrate feature, forming a recess in a surface of the substrate. A feedstock mixture including a filler material and a liquid carrier is introduced into a combustion gas stream of as HVAF apparatus. The combustion gas stream has a temperature greater than a melting point of the filler material. An entrained feedstock stream is formed from the feedstock mixture within the HVAF apparatus. The filler material is applied to the recess by expelling the filler material from the HVAF apparatus, the filler material being maintained at a temperature less than the melting point of the filler material by the liquid carrier while being expelled. The filler material and an area of the substrate bordering the recess are heat treated, forming a treated portion.

Other features and advantages of the present invention will be apparent from the following more detailed description of the preferred embodiment, taken in conjunction with the accompanying drawings, which illustrate, by way of example, the principles of the invention.

### BRIEF DESCRIPTION OF THE DRAWINGS

FIG. 1 is a perspective view of a portion of an article, according to an embodiment of the present disclosure.
FIG. 2 is a perspective view of a portion of the article of FIG. 1 following removal of a portion of the substrate, according to an embodiment of the present disclosure.
FIG. 3 is a perspective view of a portion of the article of FIG. 2 with a schematic representation of an HVAF Apparatus during application of filler material to the recess, according to an embodiment of the present disclosure.
FIG. 4 is a perspective view of a portion of the article of FIG. 1 having a treated portion, according to an embodiment of the present disclosure.
FIG. 5 is a schematic view of an HVAF spray gun, according to an embodiment of the present disclosure.

Wherever possible, the same reference numbers will be used throughout the drawings to represent the same parts.

### DETAILED DESCRIPTION OF THE INVENTION

Provided are exemplary methods for treating articles and turbine components. Embodiments of the present disclosure, in comparison to methods not utilizing one or more features disclosed herein, reduce or eliminate the need to design and test for a new material, improve reparability, durability, tensile strength, fatigue resistance, creep resistance, oxidation rate, corrosion rate, elastic modulus, thermal expansion coefficient, Poisson's ratio, specific heat, density, process efficiency, material efficiency, or a combination thereof.

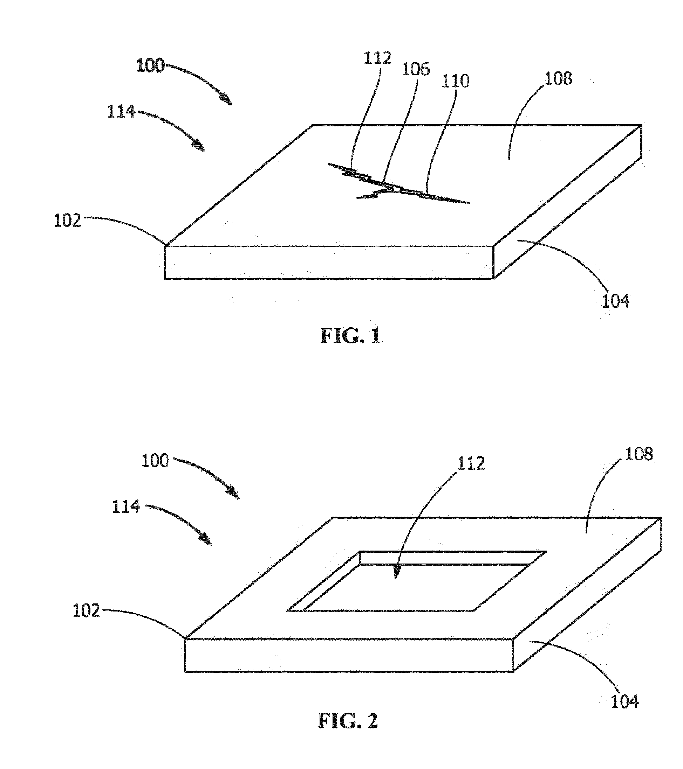

Referring to FIG. 1, in one embodiment, an article treatment method includes providing the article 100 including a substrate 102 composed of a substrate material 104. The substrate 102 includes an undesirable substrate feature 106 in a surface 108 of the substrate 102. The undesirable substrate feature 106 may include, but is not limited to, a crack 110, a divot, a pore, a deviant grain, an abrasion, a mechanical anomaly, a chemical anomaly, a crystalline anomaly, a structural anomaly, or a combination thereof. The undesirable substrate feature 106 may include a recess 112 in the surface 108 of the substrate 102, such as, but not limited to, a crack 110, a divot, a pore, or a combination thereof.

In one embodiment, the article 100 is a turbine component 114. The turbine component 114 may be any suitable turbine component 114, including, but not limited to, a hot gas path component, a blade (bucket), a nozzle (vane), a shroud, a combustor, a turbine wheel, a rotating turbine component, a wheel, a seal, a 3d-manufactured component with HTW alloys, or a combination thereof.

In one embodiment, the substrate material 104 is an HTW alloy. As used herein, an "HTW alloy" is an alloy which exhibits liquation, weld and strain-age cracking, and which is therefor impractical to weld. In a further embodiment, the HTW alloy is a superalloy. In yet a further embodiment, the HTW alloy is a nickel-based superalloy or aluminum-titanium superalloy. The HTW alloy may include, but is not limited to, GTD 111, GTD 444, GTD262, René N2, René N4, René N5, René N6, René 65, René 77 (Udimet 700), René 80, René 88DT, René 104, René 108, René 125, René 142, René 195, René N500, René N515, CM247, MarM247, CMSX-4, MGA1400, MGA2400, IN100, INCONEL 700, INCONEL 738, INCONEL 792, DS Siemet, CMSX10, PWA1480, PWA1483, PWA 1484, TMS-75, TMS-82, Mar-M-200, UDIMET 500, ASTROLOY, and combinations thereof.

As used herein, "ASTROLOY" refers to an alloy including a composition, by weight, of about 15% chromium, about 17% cobalt, about 5.3% molybdenum, about 4% aluminum, about 3.5% titanium, and a balance of nickel.

As used herein, "DS Siemet" refers to an alloy including a composition, by weight, of about 9% cobalt, about 12.1% chromium, about 3.6% aluminum, about 4% titanium, about 5.2% tantalum, about 3.7% tungsten, about 1.8% molybdenum, and a balance of nickel.

As used herein, "GTD111" refers to an alloy including a composition, by weight, of about 14% chromium, about 9.5% cobalt, about 3.8% tungsten, about 4.9% titanium, about 3% aluminum, about 0.1% iron, about 2.8% tantalum, about 1.6% molybdenum, about 0.1% carbon, and a balance of nickel.

As used herein, "GTD262" refers to an alloy including a composition, by weight, of about 22.5% chromium, about 19% cobalt, about 2% tungsten, about 1.35% niobium, about 2.3% titanium, about 1.7% aluminum, about 0.1% carbon, and a balance of nickel.

As used herein, "GTD444" refers to an alloy including a composition, by weight, of about 7.5% cobalt, about 0.2% iron, about 9.75% chromium, about 4.2% aluminum, about 3.5% titanium, about 4.8% tantalum, about 6% tungsten, about 1.5% molybdenum, about 0.5% niobium, about 0.2% silicon, about 0.15% hafnium, and a balance of nickel.

As used herein, "MGA1400" refers to an alloy including a composition, by weight, of about 10% cobalt, about 14% chromium, about 4% aluminum, about 2.7% titanium, about 4.7% tantalum, about 4.3% tungsten, about 1.5% molybdenum, about 0.1% carbon, and a balance of nickel.

As used herein, "MGA2400" refers to an alloy including a composition, by weight, of about 19% cobalt, about 19% chromium, about 1.9% aluminum, about 3.7% titanium, about 1.4% tantalum, about 6% tungsten, about 1% niobium, about 0.1% carbon, and a balance of nickel.

As used herein, "PMA 1480" refers to an alloy including a composition, by weight, of about 10% chromium, about 5% cobalt, about 5% aluminum, about 1.5% titanium, about 12% tantalum, about 4% tungsten, and a balance of nickel.

As used herein, "PWA1483" refers to an alloy including a composition, by weight, of about 9% cobalt, about 12.2% chromium, about 3.6% aluminum, about 4.1% titanium, about 5% tantalum, about 3.8% tungsten, about 1.9% molybdenum, and a balance of nickel.

As used herein, "PMA 1484" refers to an alloy including a composition, by weight, of about 5% chromium, about 10% cobalt, about 2% molybdenum, about 5.6% aluminum, about 9% tantalum, about 6% tungsten, and a balance of nickel.

As used herein, "René N2" refers to an alloy including a composition, by weight, of about 7.5% cobalt, about 13% chromium, about 6.6% aluminum, about 5% tantalum, about 3.8% tungsten, about 1.6% rhenium, about 0.15% hafnium, and a balance of nickel.

As used herein, "René N4" refers to an alloy including a composition, by weight, of about 9.75% chromium, about 7.5% cobalt, about 4.2% aluminum, about 3.5% titanium, about 1.5% molybdenum, about 6.0% tungsten, about 4.8% tantalum, about 0.5% niobium, about 0.15% hafnium, and a balance of nickel.

As used herein, "René N5" refers to an alloy including a composition, by weight, of about 7.5% cobalt, about 7.0% chromium, about 6.5% tantalum, about 6.2% aluminum, about 5.0% tungsten, about 3.0% rhenium, about 1.5% molybdenum, about 0.15% hafnium, and a balance of nickel.

As used herein, "René N6" refers to an alloy including a composition, by weight, of about 12.5% cobalt, about 4.2% chromium, about 7.2% tantalum, about 5.75% aluminum, about 6% tungsten, about 5.4% rhenium, about 1.4% molybdenum, about 0.15% hafnium, and a balance of nickel.

As used herein, "René 65" refers to an alloy including a composition, by weight, of about 13% cobalt, up to about 1.2% iron, about 16% chromium, about 2.1% aluminum, about 3.75% titanium, about 4% tungsten, about 4% molybdenum, about 0.7% niobium, up to about 0.15% manganese, and a balance of nickel.

As used herein, "René 77 (Udimet 700)" refers to an alloy including a composition, by weight, of about 15% chromium, about 17% cobalt, about 5.3% molybdenum, about 3.35% titanium, about 4.2% aluminum, and a balance of nickel.

As used herein, "René 80" refers to an alloy including a composition, by weight, of about 14% chromium, about 9.5% cobalt, about 4% molybdenum, about 3% aluminum, about 5% titanium, about 4% tungsten, about 0.17% carbon, and a balance of nickel.

As used herein, "René 88DT" refers to an alloy including a composition, by weight, of about 16% chromium, about 13% cobalt, about 4% molybdenum, about 0.7% niobium, about 2.1 % aluminum, about 3.7% titanium, about 4% tungsten, about 0.1 % rhenium, a maximum of about 4.3% rhenium and tungsten, and a balance of nickel.

As used herein, "René 104" refers to an alloy including a composition, by weight, of about 13.1% chromium, about 18.2% cobalt, about 3.8% molybdenum, about 1.9% tungsten, about 1.4% niobium, about 3.5% aluminum, about 3.5% titanium, about 2.7% tantalum, and a balance of nickel.

As used herein, "René 108" refers to an alloy including a composition, by weight, of about 8.4% chromium, about 9.5% cobalt, about 5.5% aluminum, about 0.7% titanium, about 9.5% tungsten, about 0.5% molybdenum, about 3% tantalum, about 1.5% hafnium, and a balance of nickel.

As used herein, "René 125" refers to an alloy including a composition, by weight, of about 8.5% chromium, about 10% cobalt, about 4.8% aluminum, up to about 2.5% titanium, about 8% tungsten, up to about 2% molybdenum, about 3.8% tantalum, about 1.4% hafnium, about 0.11% carbon, and a balance of nickel.

As used herein, "René 142" refers to an alloy including a composition, by weight, of about 6.8% chromium, about 12% cobalt, about 6.1% aluminum, about 4.9% tungsten, about 1.5% molybdenum, about 2.8% rhenium, about 6.4% tantalum, about 1.5% hafnium, and a balance of nickel.

As used herein, "René 195" refers to an alloy including a composition, by weight, of about 7.6% chromium, about 3.1% cobalt, about 7.8% aluminum, about 5.5% tantalum, about 0.1% molybdenum, about 3.9% tungsten, about 1.7% rhenium, about 0.15% hafnium, and a balance of nickel.

As used herein, "René N500" refers to an alloy including a composition, by weight, of about 7.5% cobalt, about 0.2% iron, about 6% chromium, about 6.25% aluminum, about 6.5% tantalum, about 6.25% tungsten, about 1.5% molybdenum, about 0.15% hafnium, and a balance of nickel.

As used herein, "René N515" refers to an alloy including a composition, by weight, of about 7.5% cobalt, about 0.2% iron, about 6% chromium, about 6.25% aluminum, about 6.5% tantalum, about 6.25% tungsten, about 2% molybdenum, about 0.1% niobium, about 1.5% rhenium, about 0.6% hafnium, and a balance of nickel.

As used herein, "MarM247" and "CM247" refer to an alloy including a composition, by weight, of about 5.5% aluminum, about 0.15% carbon, about 8.25% chromium, about 10% cobalt, about 10% tungsten, about 0.7% molybdenum, about 0.5% iron, about 1% titanium, about 3% tantalum, about 1.5% hafnium, and a balance of nickel.

As used herein, "IN100" refers to an alloy including a composition, by weight, of about 10% chromium, about 15% cobalt, about 3% molybdenum, about 4.7% titanium, about 5.5% aluminum, about 0.18% carbon, and a balance of nickel.

As used herein, "INCONEL 700" refers to an alloy including a composition, by weight, of up to about 0.12% carbon, about 15% chromium, about 28.5% cobalt, about 3.75% molybdenum, about 2.2% titanium, about 3% aluminum, about 0.7% iron, up to about 0.3% silicon, up to about 0.1% manganese, and a balance of nickel.

As used herein, "INCONEL 738" refers to an alloy including a composition, by weight, of about 0.17% carbon, about 16% chromium, about 8.5% cobalt, about 1.75% molybdenum, about 2.6% tungsten, about 3.4% titanium, about 3.4% aluminum, about 0.1% zirconium, about 2% niobium, and a balance of nickel.

As used herein, "INCONEL 792" refers to an alloy including a composition, by weight, of about 12.4% chromium, about 9% cobalt, about 1.9% molybdenum, about 3.8% tungsten, about 3.9% tantalum, about 3.1% aluminum, about 4.5% titanium, about 0.12% carbon, about about 0.1% zirconium, and a balance of nickel.

As used herein, "UDIMET 500" refers to an alloy including a composition, by weight, of about 18.5% chromium, about 18.5% cobalt, about 4% molybdenum, about 3% titanium, about 3% aluminum, and a balance of nickel.

As used herein, "Mar-M-200" refers to an alloy including a composition, by weight, of about 9% chromium, about 10% cobalt, about 12.5% tungsten, about 1% columbium, about 5% aluminum, about 2% titanium, about 10.14% carbon, about 1.8% hafnium, and a balance of nickel.

As used herein, "TMS-75" refers to an alloy including a composition, by weight, of about 3% chromium, about 12% cobalt, about 2% molybdenum, about 6% tungsten, about 6% aluminum, about 6% tantalum, about 5% rhenium, about 0.1% hafnium, and a balance of nickel.

As used herein, "TMS-82" refers to an alloy including a composition, by weight, of about 4.9% chromium, about 7.8% cobalt, about 1.9% molybdenum, about 2.4% rhenium, about 8.7% tungsten, about 5.3% aluminum, about 0.5% titanium, about 6% tantalum, about 0.1% hafnium, and a balance of nickel.

As used herein, "CMSX-4" refers to an alloy including a composition, by weight, of about 6.4% chromium, about 9.6% cobalt, about 0.6% molybdenum, about 6.4% tungsten, about 5.6% aluminum, about 1.0% titanium, about 6.5% tantalum, about 3% rhenium, about 0.1% hafnium, and a balance of nickel.

As used herein, "CMSX-10" refers to an alloy including a composition, by weight, of about 2% chromium, about 3% cobalt, about 0.4% molybdenum, about 5% tungsten, about 5.7% aluminum, about 0.2% titanium, about 8% tantalum, about 6% rhenium, and a balance of nickel.

Referring to FIGS. 1 and 2, in one embodiment (as shown in FIG. 1), the undesirable substrate feature 106 is a recess 112 in the surface 108 of the substrate 102. In another embodiment (not shown), the undesirable substrate feature 106 is not limited to a recess 112, such as, but not limited to, a deviant grain, a mechanical anomaly, a chemical anomaly, a crystalline anomaly, a structural anomaly, or a combination thereof. Referring to FIG. 2, in one embodiment, where the undesirable substrate feature 106 includes an undesirable feature which not limited to a recess 112, or where the recess 112 is insufficiently accessible to be filled, a portion of the substrate 102 containing the undesirable substrate feature 106 is removed, forming a recess 112 in the surface 108 of the substrate 102. As used herein, "forming a recess 112" includes expanding an existing recess 112 to increase the accessibility of the recess 112.

The recess 112 may be prepared by removing surface oxides. Surface oxides may be removed by any suitable technique, including, but not limited to, mechanically abrading the recess 112, chemically etching the recess 112, thermally cleaning the recess 112 under vacuum, or combinations thereof. Mechanically abrading the recess 112 may include grit blasting the recess 112. In one embodiment, the surface 108 is preserved in an oxide-free state after removing the surface oxides until filling the recess 112.

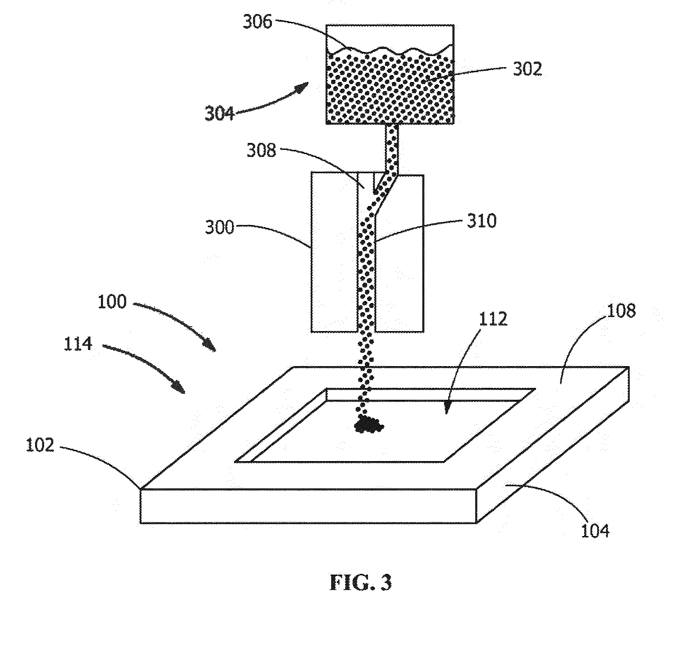

Referring to FIG. 3, an HVAF apparatus 300 applies a filler material 302 to the recess 112 (although shown with respect to an excavated recess 112, the filler material 302 may also be applied to a recess 112 which has not been excavated provided that the recess 112 is sufficiently accessible). A feedstock mixture 304 including the filler material 302 and a liquid carrier 306 is introduced into a combustion gas stream 308 of the HVAF apparatus 300, wherein the combustion gas stream 308 has a temperature greater than the melting point of the filler material 302. An entrained feedstock stream 310 is formed from the feedstock mixture 304 within the HVAF apparatus 300, and the filler material 302 is applied to the recess 112 by expelling the filler material 302 from the HVAF apparatus 300. The filler material 302 is maintained at a temperature less than the melting point of the filler material 302 by the liquid carrier 306 while the filler material 302 is expelled. In one embodiment, the filler material 302 is maintained at a temperature less than the melting point of the filler material 302 by the liquid carrier 306 while the feedstock mixture 304 is introduced into the HVAF apparatus 300. In one embodiment, applying the filler material 302 includes filling the recess 112 with the filler material 302 at least to the surface 108 of the substrate 102.

The filler material 302 may be any suitable material compatible with the substrate material 104. As used herein, "compatible" indicates that the filler material 302 is capable of forming a bond with the substrate material 104 which does not detach under operating conditions of the article 100, that the filler material 302 and the substrate material 104 are chemically compatible, that the filler material 302 and the substrate material 104 are physically compatible, and further that includes a physical property that is at least about 50%, alternatively at least about 60%, alternatively at least about 70%, alternatively at least about 80%, alternatively at least about 90%, of a corresponding physical property of the substrate material 104. The physical property may be any suitable physical property, including, but not limited to, tensile strength, fatigue resistance, creep resistance, oxidation rate, corrosion rate, elastic modulus, thermal expansion coefficient, Poisson's ratio, specific heat, density, or a combination thereof. In one embodiment, the filler material 302 is the substrate material 104.

The liquid carrier 306 may be any suitable liquid, including, but not limited to, water, an alcohol an organic solvent, or a combination thereof. The liquid carrier 306 may also include a surfactant. Without being bound by theory, it is believed that the additional of a surfactant may improve dispersion of the filler material 302 in the liquid carrier 306.

In one embodiment, the feedstock mixture 304 includes, by weight, less than about 90% filler material 302 in liquid carrier 306, alternatively less than about 70% filler material 302 in liquid carrier 306, alternatively less than about 50% filler material 302 in liquid carrier 306, alternatively less than about 30% filler material 302 in liquid carrier 306, alternatively between about 1% to about 20% filler material 302 in liquid carrier 306, alternatively between about 2% to about 10% filler material 302 in liquid carrier 306.

In one embodiment, applying the filler material 302 to the recess 112 includes applying the filler material 302 having an average particle size less than about 50 µm, alternatively less than about 40 µm, alternatively less than about 30 µm, alternatively less than about 20 µm, alternatively less than about 15 µm, alternatively less than about 10 µm, alternatively less than about 5 µm.

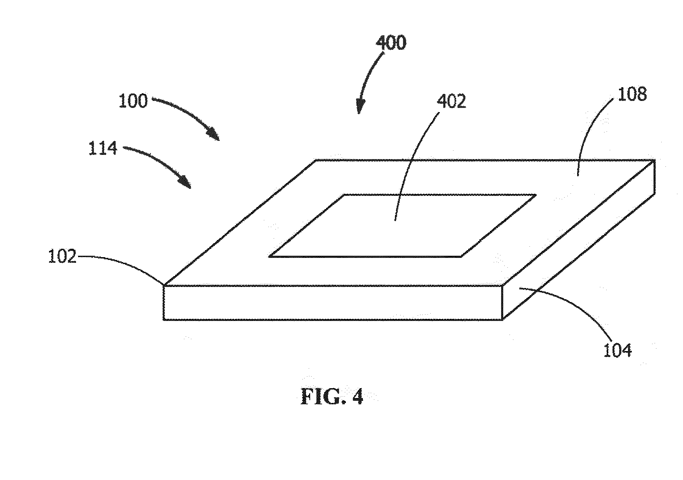

Referring to FIG. 4 (in view of FIG. 3), in one embodiment, the filler material 302 in the recess 112 is finished, forming a filler material surface 402 substantially flush with the surface 108 of the substrate 102. As used herein, "substantially flush" indicates that filler material surface 402 does not vary significantly from the overall conformation of the surface 108, and that where the filler material surface 402 and the surface 108 meet, the variance in height relative to one another does not exceed operational tolerances for the article 100, and does not exceed about 0.6 µm, alternatively about 0.8 µm, alternatively about 1 µm. Finishing the filler material 302 may include applying any suitable finishing technique, including, but not limited to, grinding, polishing, peening, or a combination thereof.

The filler material 302 and an area of the substrate 102 bordering the recess 112 are heat treated, forming a treated portion 400. In one embodiment, the heat treating includes standard heat treating process steps and parameters for the substrate material 104. In a further embodiment, heat treating includes heating the filler material 302 and an area of the substrate 102 bordering the recess 112 under vacuum or inert atmosphere to a predetermined temperature. The predetermined temperature may be any suitable temperature with respect to the material being heat treated. In one embodiment, the predetermined temperature is between about 1,000 °C to about 1,500 °C, alternatively between about 1,100 °C to about 1,350 °C. Heat treating may further include a predetermined temperature ramping program to the predetermined temperature, a hold time at the predetermined temperature, a predetermined temperature quenching program from the predetermined temperature, or a combination thereof. In another embodiment, heat treating includes hot isostatic pressing.

In one embodiment, heat treating the filler material 302 and an area of the substrate 102 bordering the recess 112 precedes finishing the filler material 302 in the recess 112. In another embodiment, heat treating the filler material 302 and an area of the substrate 102 bordering the recess 112 follows finishing the filler material 302 in the recess 112.

In one embodiment, forming the treated portion 400 includes developing a physical property that is at least about 50%, alternatively at least about 60%, alternatively at least about 70%, alternatively at least about 80%, alternatively at least about 90%, of a corresponding physical property of the substrate 102. The physical property may be any suitable physical property, including, but not limited to, tensile strength, fatigue resistance, creep resistance, oxidation rate, corrosion rate, elastic modulus, thermal expansion coefficient, Poisson's ratio, specific heat, density, or a combination thereof.

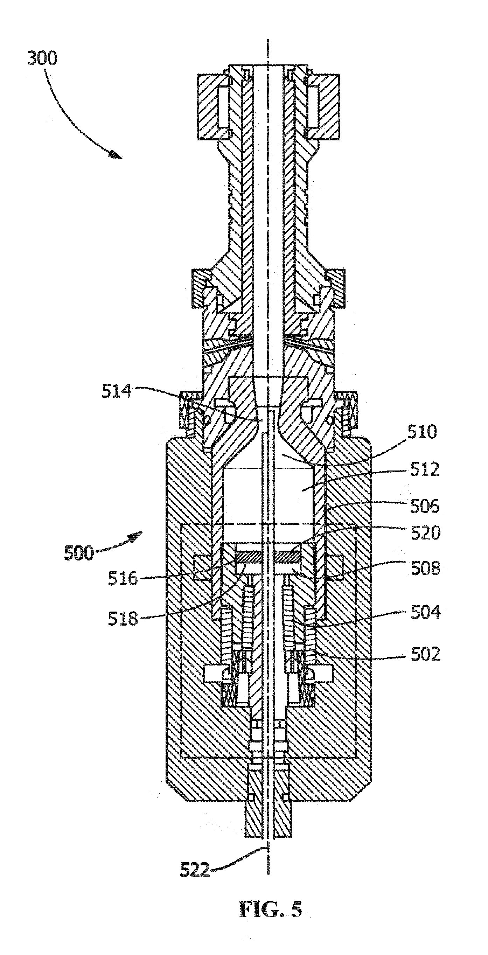

Referring to FIG. 5, in one embodiment, the HVAF apparatus is an HVAF spray gun 500. A suitable HVAF spray gun 500 is described in U.S. Patent Application 12/790,170 (filed May 28, 2010), the disclosures of which are incorporated herein in their entirety. The HVAF spray gun 500 includes at least one air injection port 502 and at least one fuel injection port 504 which feed air and fuel, respectively, to a combustion chamber 506. The combustion chamber 506 includes an inlet side 508 and an outlet side 510, and a combustion zone 512 between the inlet side 508 and the outlet side 510. The HVAF spray gun 500 ignites the fuel/air mixture in the combustion zone 512 of the combustion chamber 506. A nozzle 514 is disposed in the outlet side 510 of the combustion chamber 506, which accelerates the combustion gases to high velocities. The nozzle 514 may include any suitable geometry. In one embodiment, the velocities of the combustion gases are in excess of about 600 meters per second. The combustion chamber 506 may include a permeable burner block 516, with an upstream face 518 and a downstream face 520, disposed in the combustion chamber 506. The permeable burner block 516 may assist with the generation of a high-velocity combustion gas stream 308. In one embodiment, the permeable burner block 516 is disposed in the combustion zone 512 of the combustion chamber 506. In one embodiment, the permeable burner block 516 receives the fuel from the at least one fuel injection port 504 and helps in efficient combustion of the fuel to assist with the generation of a high-velocity combustion gas stream 308. In one embodiment, the permeable burner block 516 includes a plurality of orifices (not shown) that help in transporting the fuel for efficient combustion in the combustion zone 512. In one embodiment, the permeable burner block 516 includes a ceramic material. In another embodiment, the permeable burner block 516 is a catalytic plate. The HVAF spray gun 500 further includes a feedstock mixture injection port 522.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

Various aspects and embodiments of the present invention are defined by the following clauses:
1. An article treatment method, comprising:
   introducing a feedstock mixture including a filler material and a liquid carrier into a combustion gas stream of a high-velocity-air-fuel (HVAF) apparatus, the combustion gas stream having a temperature greater than a melting point of the filler material;
   forming an entrained feedstock stream from the feedstock mixture within the HVAF apparatus;
   applying the filler material to an article including a substrate composed of a substrate material, the substrate including an undesirable substrate feature, the undesirable substrate feature including a recess in a surface of the substrate, wherein applying the filler material to the article includes applying the filler material to the recess by expelling the filler material from the HVAF apparatus, the filler material being maintained at a temperature less than the melting point of the filler material by the liquid carrier while being expelled; and
   heat treating the filler material and an area of the substrate bordering the recess, forming a treated portion.
2. The method of clause 1, wherein applying the filler material to the article includes applying the filler material to the article having the substrate material including a hard-to-weld (HTW) alloy.
3. The method of clause 1, wherein applying the filler material to the article includes applying the filler material to a turbine component as the article.
4. The method of clause 1, further including preparing the recess by removing surface oxides by a preparation process selected from the group consisting of mechanically abrading the recess, chemically etching the recess, thermally cleaning the recess under vacuum, and combinations thereof.
5. The method of clause 1, wherein applying the filler material to the recess includes applying the filler material having an average particle size less than about 20 µm.
6. The method of clause 1, wherein applying the filler material to the recess includes applying the substrate material as the filler material.
7. The method of clause 1, wherein applying the filler material includes filling the recess with the filler material, forming a filler material surface substantially flush with the surface of the substrate.
8. The method of clause 1, further including finishing the filler material in the recess by applying a finishing technique selected from the group consisting of grinding, polishing, peening, and combinations thereof.
9. The method of clause 1, wherein heat treating includes standard heat treating process steps and parameters for the substrate material.
10. The method of clause 1, wherein forming the treated portion includes developing a physical property that is at least about 80% of a corresponding physical property of the substrate, the physical property being selected from the group consisting of tensile strength, fatigue resistance, creep resistance, oxidation rate, corrosion rate, elastic modulus, thermal expansion coefficient, Poisson's ratio, specific heat, density and combinations thereof.
11. An article treatment method, comprising:
   removing a portion of a substrate of an article, the substrate being composed of a substrate material, the portion of the substrate containing an undesirable substrate feature, forming a recess in a surface of the substrate;
   introducing a feedstock mixture including a filler material and a liquid carrier into a combustion gas stream of a high-velocity-air-fuel (HVAF) apparatus, the combustion gas stream having a temperature greater than a melting point of the filler material;
   forming an entrained feedstock stream from the feedstock mixture within the HVAF apparatus;
   applying the filler material to the recess by expelling the filler material from the HVAF apparatus, the filler material being maintained at a temperature less than the melting point of the filler material by the liquid carrier while being expelled; and
   heat treating the filler material and an area of the substrate bordering the recess, forming a treated portion.
12. The method of clause 11, wherein removing the portion of the substrate includes removing the portion of the substrate having the substrate material including a hard-to-weld (HTW) alloy.
13. The method of clause 11, wherein removing the portion of the substrate of the article includes removing the portion of the substrate of a turbine component as the article.
14. The method of clause 11, further including preparing the recess by removing surface oxides by a preparation process selected from the group consisting of mechanically abrading the recess, chemically etching the recess, thermally cleaning the recess under vacuum, and combinations thereof.
15. The method of clause 11, wherein applying the filler material to the recess includes applying the filler material having an average particle size less than about 20 µm.
16. The method of clause 11, wherein applying the filler material to the recess includes applying the substrate material as the filler material.
17. The method of clause 11, wherein applying the filler material includes filling the recess with the filler material, forming a filler material surface substantially flush with the surface of the substrate.
18. The method of clause 11, further including finishing the filler material in the recess by applying a finishing technique selected from the group consisting of grinding, polishing, peening, and combinations thereof.
19. The method of clause 11, wherein heat treating includes standard heat treating process steps and parameters for the substrate material.
20. The method of clause 11, wherein forming the treated portion includes developing a physical property that is at least about 80% of a corresponding physical property of the substrate, the physical property being selected from the group consisting of tensile strength, fatigue resistance, creep resistance, oxidation rate, corrosion rate, elastic modulus, thermal expansion coefficient, Poisson's ratio, specific heat, density and combinations thereof.

## Claims

1. An article (100) treatment method, comprising:
introducing a feedstock mixture (304) including a filler material (302) and a liquid carrier (306) into a combustion gas stream (308) of a high-velocity-air-fuel (HVAF) apparatus (300), the combustion gas stream (308) having a temperature greater than a melting point of the filler material (302);
forming an entrained feedstock stream (310) from the feedstock mixture (304) within the HVAF apparatus (300);
applying the filler material (302) to an article (100) including a substrate (102) composed of a substrate material (104), the substrate (102) including an undesirable substrate feature (106), the undesirable substrate feature (106) including a recess (112) in a surface (108) of the substrate (102), wherein applying the filler material (302) to the article (100) includes applying the filler material (302) to the recess (112) by expelling the filler material (302) from the HVAF apparatus (300), the filler material (302) being maintained at a temperature less than the melting point of the filler material (302) by the liquid carrier (306) while being expelled; and
heat treating the filler material (302) and an area of the substrate (102) bordering the recess (112), forming a treated portion (400).

2. The method of claim 1, wherein applying the filler material (302) to the article (100) includes applying the filler material (302) to the article (100) having the substrate material (104) including a hard-to-weld (HTW) alloy.

3. The method of claim 1, further including preparing the recess (112) by removing surface oxides by a preparation process selected from the group consisting of mechanically abrading the recess (112), chemically etching the recess (112), thermally cleaning the recess (112) under vacuum, and combinations thereof.

4. The method of claim 1, wherein applying the filler material (302) to the recess (112) includes applying the filler material (302) having an average particle size less than about 20 µm.

5. The method of claim 1, wherein applying the filler material (302) to the recess (112) includes applying the substrate material (104) as the filler material (302).

6. The method of claim 1, wherein heat treating includes standard heat treating process steps and parameters for the substrate material (104).

7. The method of claim 1, wherein forming the treated portion (400) includes developing a physical property that is at least about 80% of a corresponding physical property of the substrate (102), the physical property being selected from the group consisting of tensile strength, fatigue resistance, creep resistance, oxidation rate, corrosion rate, elastic modulus, thermal expansion coefficient, Poisson's ratio, specific heat, density and combinations thereof.

8. An article (100) treatment method, comprising:
removing a portion of a substrate (102) of an article (100), the substrate (102) being composed of a substrate material (104), the portion of the substrate (102) including an undesirable substrate feature (106), forming a recess (112) in a surface (108) of the substrate (102);
introducing a feedstock mixture (304) including a filler material (300) and a liquid carrier (306) into a combustion gas stream (308) of a high-velocity-air-fuel (HVAF) apparatus (300), the combustion gas stream (308) having a temperature greater than a melting point of the filler material (302);
forming an entrained feedstock stream (310) from the feedstock mixture (304) within the HVAF apparatus (300);
applying the filler material (302) to the recess (112) by expelling the filler material (302) from the HVAF apparatus (300), the filler material (302) being maintained at a temperature less than the melting point of the filler material (302) by the liquid carrier (306) while being expelled; and
heat treating the filler material (302) and an area of the substrate (102) bordering the recess (112), forming a treated portion (400).

9. The method of claim 8, wherein removing the portion of the substrate (102) includes removing the portion of the substrate (102) having the substrate material (104) including a hard-to-weld (HTW) alloy.

10. The method of claim 8, further including preparing the recess (112) by removing surface oxides by a preparation process selected from the group consisting of mechanically abrading the recess (112), chemically etching the recess (112), thermally cleaning the recess (112) under vacuum, and combinations thereof.

11. The method of claim 8, wherein applying the filler material (302) to the recess (112) includes applying the filler material (302) having an average particle size less than about 20 µm.

12. The method of claim 8, wherein applying the filler material (302) to the recess (112) includes applying the substrate material (104) as the filler material (302).

13. The method of claim 8, wherein heat treating includes standard heat treating process steps and parameters for the substrate material (104).

14. The method of claim 8, wherein forming the treated portion (400) includes developing a physical property that is at least about 80% of a corresponding physical property of the substrate (102), the physical property being selected from the group consisting of tensile strength, fatigue resistance, creep resistance, oxidation rate, corrosion rate, elastic modulus, thermal expansion coefficient, Poisson's ratio, specific heat, density and combinations thereof.
